Europäisches Patentamt

European Patent Office

Office européen des brevets

(19)

(11) **EP 0 469 381 B1**

(12) **EUROPÄISCHE PATENTSCHRIFT**

(45) Veröffentlichungstag und Bekanntmachung des Hinweises auf die Patenterteilung:
**02.10.1996  Patentblatt 1996/40**

(51) Int Cl.$^6$: **G06F 11/22**

(21) Anmeldenummer: **91111879.2**

(22) Anmeldetag: **16.07.1991**

(54) **Verfahren zum dynamischen Prüfen von digitalen Logikschaltungen**

Method for dynamic testing of digital logical circuits

Procédé pour l'examination dynamique des circuits logiques numériques

(84) Benannte Vertragsstaaten:
**AT BE CH DE FR GB IT LI LU NL**

(30) Priorität: **03.08.1990  DE 4024736**

(43) Veröffentlichungstag der Anmeldung:
**05.02.1992  Patentblatt 1992/06**

(73) Patentinhaber: **SIEMENS AKTIENGESELLSCHAFT 80333 München (DE)**

(72) Erfinder: **Traub, Karl W-8037 Olching (DE)**

(56) Entgegenhaltungen:
**EP-A- 0 366 553**

**Beschreibung**

Die Erfindung betrifft ein Verfahren gemäß dem Oberbegriff des Patentanspruches 1.

Unter dem Begriff "dynamisches Prüfen von Logikschaltungen" soll hier zweierlei verstanden werden.

Während der Entwicklung einer digitalen Logikschaltung wird mit Hilfe eines Logiksimulators das Verhalten einer Schaltung untersucht, und auf Übereinstimmung mit dem Sollverhalten unter Echtzeitbedingungen geprüft.

Bei der Herstellung, z.B. als integrierte Schaltung, wird mit einem Prüfautomaten jedes Exemplar getestet, indem sein Verhalten mit dem einer fehlerfreien Schaltung auf Übereinstimmung geprüft wird. Auch hier ist es wünschenswert, den Test mit Echtzeit ablaufen zu lassen.

In beiden Fällen wird an die Schaltung ein Bitmuster angelegt und die Reaktion der Ausgänge beobachtet.

Das Anlegen des Bitmusters erfolgt schrittweise in einer festgelegten zeitlichen Folge, die der Betriebsfrequenz der Schaltung entsprechen muß.

Das Prüfen der Schaltung erfolgt dadurch, daß in jeder dieser Prüfschritte zu einem festgelegten Strobezeitpunkt die an den Ausgängen gemessenen Zustände mit den zu erwartenden Sollwerten verglichen werden.

Sind nun diese Prüfschritte sehr kurz, was einer hohen Betriebsfrequenz entspricht, dann tritt das Problem auf, daß die Reaktion der Ausgänge auf die Eingangsänderungen nicht mehr innerhalb des Prüfschrittes, sondern später erfolgt. Eine eindeutige Zuordnung von Eingangs- zu Ausgangsbitmuster ist dann nicht mehr möglich.

Im Fall der Herstellung tritt zusätzlich noch das Problem auf, daß Ausgangssignale vom Prüfling zum Empfängerteil des Prüfautomaten übertragen und dort verarbeitet werden müssen. Wie vorstehend bereits erwähnt, ist damit eine eindeutige Zuordnung von Eingangs- zu Ausgangsbitmuster zusätzlich erschwert. Es ist dabei zu berücksichtigen, daß die zur Verfügung stehende Technologie Pattern-Generatoren zur Verfügung stellt, die einen Logikschaltkreis bis in den GHz-Bereich mit Eingangssignalen versorgen kann. Auf der Empfängerseite bereitet die Verarbeitung von Signalen bis zu etwa 100 MHz jedoch größte Schwierigkeiten.

Eine Verschiebung des Strobezeitpunktes ist sehr problematisch, da, abhängig von den Betriebsparametern, die Verzögerungszeiten stark schwanken (worst case/best case > 6) bzw. die zu bewertenden Ausgänge untereinander nicht die gleiche Verzögerung haben.

Bei der Entwicklung von Logikschaltungen wurde das Problem bisher so gelöst, daß der Schaltungsentwickler die Ausgänge mit Hilfe des Logiksimulators als Pulsdiagramm beobachtet hat und mit den Erwartungswerten visuell verglichen hat.

Bei Auftreten der vorstehend geschilderten Probleme einer großen zeitlichen Verzögerung zwischen Ein- und Ausgängen mußte der Entwickler entweder diese Verzögerung gedanklich kompensieren oder er hat nur noch auf die richtige Reihenfolge der Pulse in den Ausgangssignalen geachtet.

Da eine derartige Überprüfung während der Entwicklung einer Logikschaltung mehrfach durchzuführen ist, wäre ein Vorgehen wünschenswert, das nach einer einmaligen sorgfältigen Überprüfung der Funktion das ermittelte Ergebnis in einem Rechner abzuspeichern gestattet und weitere Überprüfungen durch den Rechner selbsttätig durchgeführt werden können.

Der Erfindung liegt die Aufgabe zugrunde, ein Verfahren anzugeben, bei dem sichergestellt ist, daß bei der Entwicklung und bei der Herstellung der digitalen Logikschaltung eine eindeutige Zuordnung des Eingangs- und des Ausgangsbitmusters sichergestellt ist.

Gemäß der Erfindung wird diese Aufgabe nach den kennzeichnenden Merkmalen des Patentanspruches 1 gelöst.

Im Patentanspruch 2 ist eine vorteilhafte Ausgestaltung angegeben.

Anhand der beigefügten Ausführungsbeispiele wird die Erfindung nachstehend noch näher erläutert.

Es zeigen:

Fig. 1     ein Originalbitmuster,
Fig. 2     ein durch Einfügen von Leerzyklen "gespreiztes" Bitmuster mit n = 4 Prüfzyklen,
Fig. 3     ein durch viermaliges, n-maliges Ablaufen des Testmusters wird Stroben und Bewerten nach jedem Zyklus möglich, nur das RZ-Signal ist dargestellt.

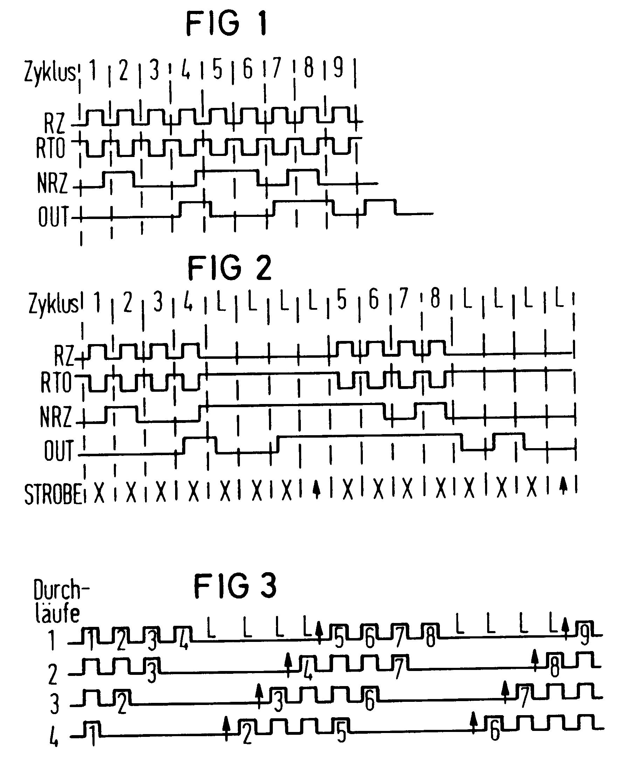

In Figur 1 ist das Originalbitmuster gezeigt. Es werden also zur Prüfung einer digitalen Logikschaltung digitale Signale zugeführt, die in einem vorgegebenen zeitlichen Abstand zyklenhaft auftreten. Der vorgegebene Abstand ist für alle Zeilen von Figur 1, im Beispiel von Figur 1 also für 9 Zyklen, gezeigt.

Figur 1 zeigt also gewissermaßen eine Schaltungseigenschaft der zu entwickelnden oder zu prüfenden Logikschaltung. In der ersten Zeile ist das Verhalten RZ dargestellt, das bekanntermaßen mit "return to zero" bezeichnet wird. Die zweite Zeile zeigt das Verhalten RTO, was bekanntlich "return to one" bedeutet. Die dritte Zeile zeigt das Verhalten NRZ, was in der Fachsprache mit "non return to zero" bezeichnet wird. Und schließlich zeigt die vierte Zeile das Verhalten OUT, was bekanntlich "Ausgang" bedeutet. Bekanntlich hat eine Logikschaltung viele Ausgänge.

In den folgenden Figuren sind für gleiche Wirkungsweisen gleiche Bezugszeichen verwendet. Es ist also in Figur 2 zu erkennen, daß Leerzyklen L an der richtigen Stelle eingefügt sind. Wie vorstehend schon erwähnt, ist in Figur 2 durch Einfügen von Leerzyklen L ein "gespreiztes" Bitmuster entstanden, und dabei ist für das Beispiel die Zahl n = 4 gewählt, wobei n die Zahl der zusammenhängenden Zyklen ist.

In Figur 3 ist die Zahl der Durchläufe dargestellt. Nur für RZ-Signal ist in den Zeilen 1, 2, 3, 4 dargestellt, wie durch viermaliges, d.h. n-maliges Ablaufen des Testmusters ein Stroben, also ein Bewerten nach jedem Zyklus möglich wird.

Im Beispiel von Figur 1 ist dargestellt, daß Ausgänge (OUT) erst etwa 3 Zyklen auf Änderung der Eingänge reagieren.

Durch Einfügen von Leerzyklen L in das Eingangsbitmuster wird der Schaltung ausreichend Zeit gelassen, um einzuschwingen. Nur am Ende dieser Leerzyklen L werden die Ausgänge bewertet. Danach läuft das Bitmuster wieder für eine festgelegte Zahl von Zyklen mit der normalen Folgefrequenz weiter (siehe Figur 1 und Figur 2). Bei den Leerzyklen L werden RZ-Signale auf Null gesetzt, RTO-Signale auf Eins und der Zustand von NRZ-Signalen vom letzten "echten" Zyklus übernommen. Nach erfolgter Simulation werden mit Ausnahme des letzten eingefügten Leerzykluses - Pfeil nach oben - alle Ausgänge auf "X" gesetzt (maskiert). Auf "X" gesetzte Ausgänge werden nicht bewertet.

Da in dem gezeigten Beispiel nur nach jedem 4. Zyklus eine Bewertung der Ausgänge stattfindet, muß in weiteren drei Durchläufen des gesamten Bitmusters dafür gesorgt werden, daß die Ausgänge auch in den restlichen Zyklen gestrobt werden (siehe Figur 3). Wieviele Testzyklen in Echtzeit hintereinander ablaufen müssen, um alle Pfade einer Schaltung zeitkritisch zu simulieren, hängt von ihrer Struktur ab. Bei nur einer Taktfrequenz genügen dazu zwei Zyklen.

Im obigen Beispiel mit vier aufeinanderfolgenden Zyklen könnte eine in der Schaltung erzeugte Takthalbierung und der damit betriebene Schaltungsteil ebenfalls in Echtzeit getestet werden, da mit vier Takten immer zwei Takte bei der halben Frequenz erzeugt werden, die ebenfalls ihren Echtzeitabstand haben.

Bei höheren Teilungen müssen entsprechend mehr Eingangstakte in Echtzeit angelegt werden.

Bei sehr hohen Teilerverhältnissen dürfte jedoch kein Zeitproblem mehr auftreten, sofern es sich um synchrone Schaltungen handelt.

Mit der Zahl der n zusammenhängenden Zyklen wächst auch die Zahl der erforderlichen Durchläufe des gesamten Bitmusters und damit der Aufwand bei der Simulation.

Für den Ablauf des Bitmusterspreizens und das Maskieren der Ausgänge gilt folgende Überlegung.

Wird die Zahl der Zyklen z nach folgender Regel bemessen, so ist das Bearbeiten des Bitmusters besonders einfach.

$$z = (n \times m) + 1$$

z ..    Zahl der Zyklen des Originalbitmusters
n ..    Zahl der zusammenhängenden Zyklen
m ..    ganze Zahl

oder

z =    Primzahl

Das Originalbitmuster wird zunächst n mal aneinandergehängt.

Bei Einhaltung der Regel für die Zahl z wird erreicht, daß durch regelmäßiges Einfügen der gewünschten Zahl von Leerzyklen über das gesamte Bitmuster hinweg in jedem der n Abschnitte die zu strobenden Zyklen an einer anderen Stelle zu liegen kommen. Dies geschieht vernünftigerweise mit einem geeigneten Rechenprogramm.

Nach erfolgter Simulation wird wieder mit einem Programm das Ergebnis bearbeitet, indem die Ausgänge in allen Zyklen bis auf den letzten in einer eingefügten Leerzyklengruppe maskiert werden. Da sich die Leerzyklen in einem festen Raster über das gesamte Bitmuster verteilen, ist auch dieses Maskieren sehr einfach durchzuführen.

Dieses Verfahren läßt sich sowohl bei der Simulation einer Schaltung als auch beim Testen im Herstellungsprozeß anwenden.

## Patentansprüche

1. Verfahren zum dynamischen Prüfen von digitalen Logikschaltungen, bei dem einer digitalen Logikschaltung digitale Signale zugeführt werden, die in einem vorgegebenen zeitlichen Abstand zyklenhaft (1 bis 9) auftreten,
und bei dem in allen Zyklen (1 bis 9) ein Erwartungswert (out) an den Ausgängen der Logikschaltung gegenüber ihren Eingängen (RZ, RTO, NRZ) festgestellt wird,
**dadurch gekennzeichnet,**
daß nach einer vorgebbaren Anzahl, die größer oder gleich 2 ist, von Prüfzyklen (n) Leerzyklen (L) eingebracht sind, die den Charakter haben, daß an den Eingangssignalen (RZ, RTO, NRZ) keine Änderungen mehr auftreten.

2. Verfahren nach Anspruch 1,
**dadurch gekennzeichnet,**
daß die Zahl der Zyklen (z) des ungespreizten Originalbitmusters eine Primzahl ist oder folgender Gleichung genügt, z = (n x m) + 1 , dabei ist z die Zahl der Prüfzyklen des Originalbitmusters, n die Zahl der zusammenhängenden Zyklen, und m eine ganze Zahl.

## Claims

1. Method for the dynamic testing of digital logic circuits, in which method digital signals which occur cyclically (1 to 9) at a prescribed time interval are fed to a digital logic circuit, and in which, in all the cycles (1 to 9) an anticipated value (out) relating to the inputs (RZ, RTO, NRZ) of the logic circuit is detected at the outputs of the logic circuit, characterized in that after a prescribed number, which is greater than or equal to 2, of test cycles (n) dummy cycles (L) are introduced which have the character that changes no longer occur at the input signals (RZ, RTO, NRZ).

2. Method according to Claim 1, characterized in that the number of cycles (z) of the unspread original bit pattern is a prime number or satisfies the following equation, $z = (n \times m) + 1$, where z is the number of test cycles of the original bit pattern, n is the number of associated cycles and m is an integer.

**Revendications**

1. Procédé de vérification dynamique de circuits logiques numériques, dans lequel on envoie des signaux numériques, qui apparaissent par cycles (1 à 9) en un laps de temps prescrit, à un circuit logique numérique,
et dans lequel on détermine aux sorties du circuit logique une espérance mathématique (out) des entrées (RZ, RTO, NRZ) pendant tous les cycles (1 à 9),
caractérisé en ce que
(n) cycles (L) vides, qui ont la caractéristique consistant en ce qu'il n'apparaît plus de modifications des signaux (RZ, RTO, NRZ) d'entrée, sont insérés après un nombre, pouvant être prescrit et supérieur ou égal à 2, de cycles de vérification.

2. Procédé suivant la revendication 1,
caractérisé en ce que
le nombre des cycles (z) du motif binaire d'origine non élargi est un nombre premier ou satisfait à l'équation suivante $z = (n \times m) + 1$, où z est le nombre des cycles de vérification du modèle binaire d'origine, n est le nombre des cycles du même genre et m est un nombre entier.

# FIG 1

Zyklus 1 | 2 | 3 | 4 | 5 | 6 | 7 | 8 | 9 |

RZ

RTO

NRZ

OUT

# FIG 2

Zyklus 1 | 2 | 3 | 4 | L | L | L | L | 5 | 6 | 7 | 8 | L | L | L | L |

RZ

RTO

NRZ

OUT

STROBE X | X | X | X | X | X | X | ↟ | X | X | X | X | X | X | X | ↟ |

# FIG 3

Durchläufe

1

2

3

4